# EUROPEAN PATENT SPECIFICATION

(11) **EP 3 863 103 B1**
(45) Date of publication and mention of the grant of the patent: **04.03.2026**
(21) Application number: 20155827.7
(22) Date of filing: 06.02.2020
(51) Int. Cl.: H01M 10/42, H01M 10/48

(54) **BATTERY SYSTEM**
BATTERIESYSTEM
SYSTÈME DE BATTERIE

(43) Date of publication of application: 11.08.2021
(73) Proprietor: Samsung SDI Co., Ltd., Gyeonggi-do 17084 (KR)
(72) Inventor: Hofer, Maximilian, 8230 Hartberg (AT); Trathnigg, Thomas, 8010 Graz (AT); Bergmayr, Werner, 8020 Graz (AT)
(74) Representative: Gulde & Partner

(56) References cited:
- EP-A1- 2 571 076
- EP-A2- 2 403 048
- US-A1- 2017 219 660

## Description

### Field of the Invention

The present invention relates to a battery system, particularly to a battery system with at least one control unit configured for authenticating at least one battery cell of the battery system. The present invention further relates to a method of a battery system, the method comprising authenticating at least one battery cell based on inherent properties of the battery system.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while highcapacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose.

Rechargeable batteries may be used as a battery module formed of a plurality of unit battery cells coupled in series and/or in parallel so as to provide a high energy density. That is, the battery module is formed by interconnecting the electrode terminals of the plurality of battery cells depending on a required amount of power and in order to realize a high-power rechargeable battery. In general, one or more battery modules are mechanically and electrically integrated, equipped with a thermal management system and set up for communication with one or more electrical consumers in order to form a battery system.

For meeting the dynamic power demands of various electrical consumers connected to the battery system a static control of battery power output and charging is not sufficient. Thus, steady or intermittent exchange of information between the battery system and the controllers of the electrical consumers is required. This information includes the battery systems actual state of charge (SoC), potential electrical performance, charging ability and internal resistance as well as actual or predicted power demands or surpluses of the consumers.

For monitoring, controlling and/or setting of the aforementioned information a battery system usually comprises a battery management system, BMS. Such control unit may be integral with the battery system or may be part of a remote controller communicating with the battery system via a suitable communication bus. In both cases, the control unit communicates with the electrical consumers via a suitable communication bus, e.g. a CAN or SPI interface.

The BMS is usually coupled to the controller of one or more electrical consumers as well as to each of the battery modules of the battery system. Usually each battery module comprises a cell supervision circuit, CSC, that is configured to maintain the communication with the BMS and with other battery modules. The CSC may be connected to the battery cells directly or via a cell connecting unit, CCU, and may be configured to monitor cell voltages, currents and/or temperatures of some or each of the battery module's battery cells. The CSC may further actively or passively balance the voltages of the individual battery cells within the module.

The service life of the aforementioned control units, i.e. BMS, BMU and CSC, might exceed the service life of the controlled battery cell(s). Hence, in principle, control units that were introduced to the market by an original equipment manufacturer, OEM, might thus be reused with replacement battery cells once the original cells quit functioning. However, such reuse may not only amount to a commercial loss for the OEM but may also pose high risks for battery malfunctions. Control units and battery cells are usually perfectly coordinated and hence using replacement battery cells may increase the risk of malfunctioning of the battery system and, in a worst case, might lead to fire, explosions and/or release of harmful substances. Hence, in order to protect the users of the battery system as well as an OEM's reputation, OEMs are interested in preventing the use of replacement battery cells.

Common measures to enable users or officials to identify original battery cells is the use of secure elements, such as e.g., holograms, barcodes, RFID transmitters or the like, fixedly connected with original battery cells. However, in order to guarantee a verification of those secure elements they need to be principally accessible, either optically or by electromagnetic transmission. However, this makes it possible to identify and to copy such secure elements. It is further known, to publish technical specifications of battery cells, such as detailed size, weight, material composition etc. in order to enable an identification of replacement battery cells. However, also in this method any information used for authentication must be made publicly available and can thus be illegitimately used to design replacement cells.

A method for authenticating battery cells are is known from EP 2571076 A1 disclosing to detect an electromagnetic radiation spectrum of a battery due to current flow and to compare the measured spectrum to a reference spectrum for authentication. The prior art US 2017/0219660 A1 discloses methods for determining a state of health, SOH, and/or state of charge, SOC; of a battery using electrochemical impedance measurements and EP 2 403 048 A2 discloses a method for detecting an internal resistance of a battery cell.lt is thus an object of the present invention to provide a battery system and a method of operating a battery system that allow for authenticating at least one battery cell of the battery system without the need to disclose or reveal any information used for the authentication.

### Description of the Invention

One or more of the drawbacks of the prior art could be avoided or at least reduced by means of the present invention. In particular, according to an aspect of the invention a battery system is provided, particularly a battery system for an electric vehicle, wherein the battery system comprises at least the following components. The battery system comprises a battery module, i.e., at least one battery module and preferably a plurality of battery modules. These battery modules are preferably connected via a high voltage, HV, line, e.g., via busbars, for providing a high voltage between a first system terminal and a second system terminal. Each battery module comprises a plurality of battery cells that are preferably connected in series and/or in parallel between a first module terminal and a second module terminal of a module.

The battery system of the present invention further comprises a control unit that is connected to the at least one battery module, preferably to all of the plurality of battery modules, and that is configured to communicate with the control module of the battery module via a data line. Preferably, the control unit is configured to communicate with the control modules of each of the plurality of battery modules via at least one data line, e.g., in a daisy chain configuration.

In the battery system of the invention further each battery module comprises a control module that is connected to the battery cells of the respective battery module and that is preferably physically connected to the battery module. The at least one control module of the battery system and preferably each of the control modules of the battery system is configured to measure voltage values, current values and temperature values of at least one battery cell of the respective battery module, preferably of multiple battery cells of the respective module. Particularly preferred, the control modules are configured as cell supervision circuits, CSCs, and the control unit of the battery system is configured as battery management system, BMS.

According to the present invention, the control unit is configured to determine an inherent physical property of at least one battery cell based on the measurement values of the control module, i.e., based on voltage, current and/or temperature values measured by a control module for a battery cell. Preferably, the control unit is configured to determine such an inherent physical property for a plurality of battery cells based on measurement values of one or more control modules for those battery cells. Therein, the control unit is either configured to determine the inherent physical property itself, i.e., to receive measurement values from at least one control module and to perform the actual calculations itself, or the control unit is configured to control at least one control module to determine the inherent physical property.

The control unit of the present invention is further configured to compare the determined inherent physical property of at least one battery cell with a reference value for the inherent physical property for that at least one battery cell. Therein, the reference value may be valid only for an individual battery cell or for a plurality of battery cells of the battery system. The control unit of the battery system is further configured to perform an authentication of the at least one battery cell based on the comparison between the determined value for the inherent physical property and the reference value for the inherent physical property. In the context of the present disclosure, performance of an authentication can lead to an authentication of the battery cell as an original battery cell or to an identification of that cell as replacement cell. The control unit is either configured to perform the steps of comparison and authentication itself or is configured to control the at least one control module to perform these steps.

Further, in the context of the present disclosure, the inherent physical property refers to an intrinsic electrical property of the at least one battery cell that is determined by the physical (and chemical) properties of the battery cell, such as e.g., the materials and amount of the electrolyte, the electrodes, the physical dimensions, the venting properties and the like. In other words, the inherent physical properties refer to a fingerprint of the battery cell that can be determined based on measuring values of electrical current, electrical voltage and/or temperature of the battery cell. In the context of the present disclosure an inherent physical property of a battery cell can thus not be changed without changing the physical (or chemical) properties of the battery cell. Further, suitable inherent physical properties are sensitive even to slight amendments in the composition, dimensioning, etc., of the battery cell and are thus likely to differ apparently between an original battery cell and a replacement battery cell.

Hence in the battery system of the invention, the inherent physical properties can be advantageously used for authentication of original battery cells without the need of using additional physical or electronic identifiers that can be identified and copied by competitors of an original equipment manufacturer, OEM. In fact, the only way to achieve similar inherent physical properties of the replacement battery cells would be to built them identically to the OEM battery cells which is however detrimental to the business model of the competitors. Further, the inherent physical properties that can be used for authentication of original battery cells are manifold and thus it is difficult for a competitor to identify the inherent physical properties used for authentication. Further, distributing the task of authenticating battery cells between a control unit, e.g., a BMS, of a battery system and control module(s), e.g., CSCs, of battery modules, makes it more complicated to analyze the authentication procedure by reverse engineering. By combining the use of variable inherent physical properties with a distributed computing infrastructure of a battery system, the present invention provides a high level of security against battery cell replacement by providing a reliable cell authentication.

According to the present invention, the control unit of the battery system is further configured to determine a deviation between the reference value and the determined inherent physical property and to authenticate the at least one battery cell if the deviation is below a predetermined (first) threshold. The threshold preferably differs for different inherent physical properties and is either pre-configured or set during operation of the battery system. In a preferred embodiment, the control unit is configured to identify the at least one battery cell as replacement battery cell, if the deviation is above a predetermined (second) threshold. Therein, the first and second thresholds may differ from each other or may be identical. The control unit is configured to perform the steps of determining the deviation and comparing it to a threshold itself or to control the at least one control module to perform these steps.

According to the invention, the battery system of the invention comprises a plurality of battery modules, wherein each battery module comprises a plurality of battery cells and a control module connected to the battery cells of this battery module. Further, according to the invention each of the control modules is configured to measure at least one voltage value, at least one current value and at least one temperature value of at least one battery cell of the battery module. Preferably, each control module is configured to measure such values for multiple, preferably all, battery cells of the battery module.

The control unit is further configured to communicate with the control modules of each of the battery modules via at least one data line and to determine the reference value based on at least one inherent physical property of at least one other battery cell determined from measurement values. In other words, the control unit is configured to obtain first measurement values of voltage, current and/or temperature of a first cell and to obtain second measurement values of voltage, current and/or temperature of a second cell different from the first cell. The control unit is then configured to determine at least one first inherent physical property of the first cell and at least one second inherent physical property of the second cell, wherein the first and second inherent physical properties are preferably of the same type and thus comparable. The control unit is thus configured to determine a certain (set of) inherent physical properties for different battery cells of the battery system and to cross-compare the inherent physical properties of these battery cells. A replacement battery cell can thus be identified based on a deviation of its inherent physical properties from a certain amount of other battery cells.

The present invention based on cross comparison of inherent physical properties of battery cells advantageously allows to do completely without pre-stored reference values. This makes it more difficult for competitors to identify and/or to amend such reference values. Further, using inherent physical properties of other battery cells of a system for authentication of a first battery cell further allows for reflecting effects of cell aging and/or environmental conditions on the inherent physical properties of the battery cells. Hence, with this embodiment the use of computationally complex battery models and/or of extended measurement sequences can be omitted or reduced in determining the inherent properties.

According to another preferred embodiment, the at least one reference value used for authenticating at least one battery cell is based on a mathematic cell model of the at least one battery cell. Such battery models are commonly used in the field to determine nominal values of battery cell properties for battery cell operation and control. According to this embodiment such battery cell models are thus put to a new use of determining at least one reference value for an inherent physical property for battery cell authentication. Battery models suitable for determining expected or nominal values of inherent physical properties of a battery cell are known to the person skilled in the art and e.g., described in the following publications: "Dynamic battery cell model and state of charge estimation", S. Wijewardana et al., Journal of Power Sources, Vol. 308, 15.03.2016, pages 109 to 120; "A Review of Li-ion Battery Equivalent Circuit Models", X. Zhang et al., Transactions on Electrical and Electronic Materials 17(6):311-316, Dec. 2016; "A review on modeling of electro-chemo-mechanics in lithium-ion batteries", Y. Zhao et al, Journal of Power Sources Vol. 413, 15.02.2019, p. 259 to 283; and "Battery energy storage system modeling: A combined comprehensive approach", M. Dubarry et al., Journal of Energy Storage, Vol. 21, Feb. 2019, pages 172 to 185.

In a preferred embodiment of the present invention, the battery system further comprises a storage module with the reference value for the inherent physical property, preferably with a plurality of reference values for inherent physical properties of multiple battery cells. The storage module preferably is a volatile or non-volatile memory, storing such at least one reference value temporarily or continuously. The storage module is preferably configured as part of the control unit thus allowing a central storage of reference value(s). Alternatively, each control module of the battery system comprises such storage module for decentralized storage of reference values of inherent physical properties during operation of the system.

In another preferred embodiment of the battery system according to the invention, the control unit is further configured to trigger the control module to perform a measurement sequence of voltage, current and/or temperature measurements of the at least one battery cell. In the context of the present disclosure a measurement sequence refers to a time series of measurements of at least one of current, voltage or temperature of a battery cell. Further, while measuring the time series other values of the battery cell might be varied and/or signals may be input to the battery cell, e.g., by inputting or drawing a current to/from the cell. Particularly preferred, the measurement sequence is designed to allow determination of a specific inherent physical property of at least one battery cell as described in detail below.

According to a particularly preferred embodiment, the measurement sequence comprises voltage, current and/or temperature measurements of at least two battery cells obtained during a predetermined time window. Further preferred, the measurement sequence comprises a first time series of voltage, current and/or temperature measurements at a first battery cell and a second time series of voltage, current and/or temperature measurements at a second battery cell, wherein the performed measurements are identical for the first time series and the second time series. By performing the measurement sequence on at least two battery cells in a predetermined time window, preferably simultaneously, the comparability of the obtained values is preferably guaranteed and/or improved. Further preferred, measurements at more than two battery cells are performed in one measurement sequence. This embodiment allows for a cross-comparison of inherent physical properties obtained in an identical manner for each of the compared battery cells and obtained with high precision.

In another particularly preferred embodiment, the control unit of the battery system is further configured to control a specified current draw from the at least one battery cell during the measurement sequence. Preferably, a terminal voltage value of the at least one battery cell is measured while a specific current is drawn from the battery cell, particularly preferred while a temporarily varying current is drawn from the at least one battery cell. The control unit is preferably configured to control the drawn current by connecting one or more loads to the at least one battery cell, e.g., via a variable resistor, or by connecting a bleed resistor to the cell.

Further preferred, the control unit is configured to control a specified current input, particularly preferred a temporarily varying current input, to the at least one battery cell during the measurement sequence. In other words, the control unit might apply a constant or varying charging current to the at least one battery cell during the measurement sequence and might further measure a voltage of the at least one battery cell while inputting the charging current. This embodiment advantageously allows determining a DC or internal resistance of the cell.

According to another preferred embodiment of the battery system, the control unit is further configured to control performance of an impedance spectroscopy on the at least one battery cell during the measurement sequence. The performance of impedance spectroscopy on battery cells for characterization of battery cells is in principal known to the skilled person and, exemplarily, described in the following publication: "Impedance Characterization and Modeling of Lithium-Ion Batteries Considering the Internal Temperature Gradient", H. Dai et al, Energies 2018, 11, 220; doi:10.3390/en11010220 as well as comparable publications.

In impedance spectroscopy resistance and capacitance of a cell can be detected by applying a sinusoidal AC excitation signal to the cell, wherein an impedance spectrum is obtained by varying frequency over a defined range. The capacitance and resistance of the battery cell can be then calculated by measurement of the in-phase and out-of-phase current responses. Using impedance as an inherent physical property allows advantageously for a high level of security regarding the authentication of the at least one battery cell of the battery system.

In a further preferred embodiment of the invention, the battery system further comprises a heating element that is thermally connected to the at least one battery cell. In a particularly preferred embodiment, the heating element is a temperature sensor, e.g., a thermistor, which can be used as a heating element by applying a heating current thereto. According to this preferred embodiment, the control unit is further configured to vary a temperature of the at least one battery cell during the measurement sequence via the heating element. Many inherent physical properties of battery cells depend on the temperature of the battery cell and hence by varying the battery cell temperature during a measurement sequence, particularly characteristic inherent physical properties, such as a temperature dependency of an internal resistance, DC resistance or impedance can be determined as an inherent physical property.

As set forth above, the battery system of the present invention allows for the authentication of battery cells of a battery system by determining inherent physical properties of the battery cell and by comparing them to reference values for such inherent physical property. In other words, the present disclosure also refers to the innovative use of inherent physical properties of battery cells, which due to their inherence did exist before in battery cells. However, by using one or more of those already known inherent physical properties as well as timedependencies, temperature dependencies or cross-correlation of these properties, a fingerprint of an original battery cell can be determined and used for authentication.

Preferably, the inherent physical property comprises at least one of an internal resistance, an impedance, a state of charge, SOC, a state of health, SOH, and a reaction dead time of the at least one battery cell. Further preferred, the inherent physical property comprises the temperature dependency of one or more of the aforementioned inherent physical properties. Further preferred, the inherent physical properties comprise the cross-dependency of two or more of the aforementioned inherent physical properties. Preferably, the inherent physical property comprises a time-series of at least one aforementioned inherent physical property.

Different inherent physical properties provide different levels of security or reliability of battery cell authentication. Exemplarily, if a DC resistance is used, the security level of the authentication is not particularly high, as a replacement cell may have a similar DC resistance. However, if the SOC is used as an inherent physical property, exemplarily the balancing time needed until the SOC plateaus can be determined in a time series of SOC. Such balancing time, particularly at low SOC, is a good comparative measure for identifying replacement cells that show an outlying balancing time compared to the other battery cells. In the context of the present disclosure, the reaction dead time of at least one battery cell refers to the time a battery needs to respond to any current drawn or input to the cell. Exemplarily, if a specific current is drawn from the battery cell, the terminal voltage of the cell will drop by a certain amount due to the internal resistance of the battery cell. However, this voltage drop occurs only after a reaction dead time after connecting the load to the battery cell. It was found that the reaction dead time of cells can be used to reliable authenticate a battery cell.

Another aspect of the present invention relates to a method of operating a battery system, particularly to a method for performing an authentication of at least one battery cell of the battery system. Therein, the method of the present invention comprises the step of measuring voltage values, current values and/or temperature values of at least one battery cell of the battery system. Such values may already be obtained during normal operation of battery cells and used for controlling and/or monitoring the performance of a common battery system. However, in the method of the present invention, an inherent physical property of the at least one battery cell is determined based on the measured values for electric current, electric voltage and/or temperature of the battery cell. Further according to the present invention, the determined inherent physical properties are then compared with reference values for the inherent physical properties and an authentication of the at least one battery cell is performed based on such comparison. By using inherent physical properties of battery cells for performing an authentication of at least one battery cell, the method of the invention advantageously allows for a reliable authentication of battery cells without the need to disclose any information used for such authentication. Further, if the authentication is performed using cross-comparison of inherent physical properties of multiple battery cells, the information for authentication might be completely buried in algorithms and difficult to identify.

In a preferred embodiment, the method of the invention further comprises the steps of determining a deviation between the reference value and the determined inherent physical property and one of the steps of authenticating the at least one battery cell, if the deviation is below a predetermined (first) threshold, and identifying the at least one battery cell as replacement battery cell, if the deviation is above a predetermined (second) threshold. Therein, the first and second threshold might be the same or different threshold values. The deviation might be determined as a difference between the determined value and the reference value of the inherent physical property. However, if the inherent physical property is represented as a graph, e.g., if the inherent physical property is temperature dependency or a time series of an inherent physical property of the battery cell, the deviation might be determined as a deviation between two graphs, e.g., by least-mean-squares or the like.

In a further preferred embodiment, the method of the invention further comprises the steps of performing a measurement sequence of voltage, current and/or temperature measurements of the at least one battery cell. Performing such measurement sequences advantageously allows to determine inherent physical properties that allow for a particular reliable authentication of a battery cell. Particularly preferred, the step of performing the measurement sequence comprises at least one of the steps of measuring voltage, current and/or temperature values of at least two battery cells obtained during a predetermined time window, drawing a specific current from and/or inputting a specific current to the at least one battery cell, and performing an impedance spectroscopy on the at least one battery cell. Performing these steps provides the advantages as described above for the battery system.

Another aspect of the present invention refers to a use of a control unit of a battery system, wherein the battery system comprises a battery module having a plurality of battery cells and a control module connected to the battery cells and comprises the control unit that is connected to the battery module and that is configured to communicate with the control module via a data line. The disclosed use of the control unit of such battery system is then for determining an inherent physical property of a battery cell based on measurement values of voltage, current and/or temperature of at least one battery cell obtained by the control module, for comparing the determined inherent physical property with a reference value for the inherent physical property and for performing an authentication of the one battery cell based on the comparison. As already set forth above, the present invention further relates to the use of inherent physical properties of battery cells, particularly of time-series or temperature dependencies of physical properties of battery cells, for authenticating the battery cells. Hence according to the present invention, measurement values that might be usually obtained in common battery systems can be advantageously used for an additional purpose in order to avoid illegitimate replacement of battery cells of a battery system.

Further aspects of the present invention are disclosed in the dependent claims or the following description of the drawings.

### Brief Description of the Drawings

Features will become apparent to those of ordinary skill in the art by describing in detail exemplary embodiments with reference to the attached drawings in which:
- Fig. 1: illustrates a schematic top view of a battery system according to an embodiment;
- Fig. 2: schematically illustrates a method according to an embodiment of the invention; and
- Fig. 3: illustrates the state of charge, SOC, over time for a plurality of battery cells.

### Detailed Description of the Drawings

Reference will now be made in detail to embodiments which are illustrated in the appended drawings. Effects and features of these embodiments, and implementation methods thereof will be described with reference to the appended drawings. In the drawings, like reference numerals denote like elements, and redundant descriptions are omitted. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art.

Accordingly, processes, elements, and techniques that are not considered necessary to those having ordinary skill in the art for a complete understanding of the aspects and features of the present invention may not be described. In the drawings, the relative sizes of elements, layers, and regions may be exaggerated for clarity. As used herein, the term "and/or" includes any and all combinations of one or more of the associated listed items. Further, the use of "may" when describing embodiments of the present invention refers to "one or more embodiments of the present invention." In the following description of embodiments, the singular form may include plural forms unless the context clearly indicates otherwise.

It will be understood that if the terms "first" and "second" are used to describe elements, these elements are limited by these terms. These terms are only used to distinguish one element from another element. For example, a first element may be named a second element and, similarly, a second element may be named a first element, without departing from the scope of the invention. Expressions such as "at least one of," when preceding a list of elements, modify the entire list of elements and do not modify the individual elements thereof.

As used herein, the term "substantially," "about," and similar terms are used as terms of approximation and not as terms of degree, and are intended to account for the inherent deviations in measured or calculated values that would be recognized by those of skill in the art. If the term "substantially" is used in combination with a feature that could be expressed using a numeric value, the term denotes a range of +/- 5% of the value centered on the value.

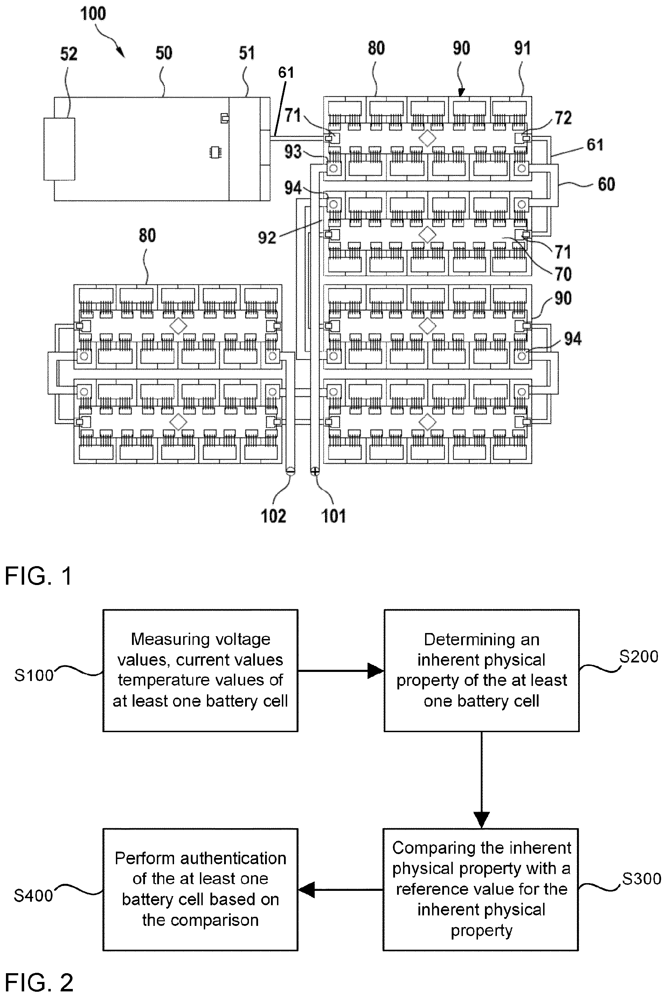

Figure 1 illustrates a schematic view of a battery system 100 according to an embodiment. Therein a plurality of battery modules 90 are electrically connected in series between a first system terminal 101 with positive polarity and a second system terminal 102 with negative polarity. Each battery module 90 comprises ten stacked prismatic battery cells 80, with five parallel connected pairs of battery cells 80 connected in series between a first module terminal 93 with positive polarity and a second module terminal 94 with negative polarity.

Each battery module 90 further comprises a control module 70, particularly a cell supervision circuit, CSC, 70 disposed on top of the stacked battery cells 80. Each CSC 70 comprises a printed circuit board as a circuit carrier with a plurality of contact pads, contact metallizations and integrated circuits that are surface mounted to the carrier. The CSC 70 is electrically connected to the terminal of each battery cell 80 and is configured for monitoring and balancing the voltage of the individual battery cells 80. Particularly, the CSC 70 is configured to measure values of electric voltage (terminal voltage), electric current and temperature of each battery cell 80. The CSC 70 further comprise a plurality of resistors that are connectable to the individual cells 80 for passively balancing the module 90 by dissipating energy of the highest voltage battery cells 80. Each CSC 70 further comprises a first signal port 71 and a second signal port 72 that are configured to interconnect the CSC 70 for data transmission.

The illustrated battery system 100 further comprises a control unit 50, particularly a battery management system, BMS, 50 that comprises a VEH converter 52 for connecting the BMS 50 to a 12 V board net of an electric vehicle. The BMS 50 further comprises a high voltage, HV, connector 51 that is configured for safely connecting the voltage domain of the plurality of battery modules 90 to the voltage domain of the board net. The battery management system 50 is further configured for communication with electric consumers connected to the board net as well as with the battery modules 90 of the battery system 100.

For data communication, the BMS 50 is coupled to the modules 90 via a daisy chain configuration. In the daisy chain configuration, the BMS 50 is coupled via a pair of data lines 61 to the first signal port 71 of a first battery module 91 that is an outermost battery module 90, i.e. connected to a battery system terminal 101. The second signal port 72 of the first battery module 91 is coupled to a first signal port 71 of a second battery module 92 again via another pair of data lines 61. In other words, a two wire data communication line spans across the battery system 100 and in between the CSCs 70 of the battery modules 90.

Additionally to this two wire data connection, the battery system 100 comprises a plurality of busbars 60, some of which are electrically connected between a second module terminal 94 of a first battery module 91 and a first module terminal 93 of a second battery terminal 92. A single busbar 60 connects a first module terminal 93 of an outermost battery cell 90 with the first system terminal 101 and another single busbar 60 interconnects a second module terminal 94 of an outermost battery cell 90 with the second system terminal 102. The busbars 60 realize power transmission of the battery cells 80 to the battery system terminals.

The battery system 100 as illustrated in Figure 1 is configured to perform a method as schematically illustrated in Figure 2. Particularly, the control unit 50 is configured to control each of the control modules 70 to measure voltage values, current values and temperature values of at least one battery cell 80 of the respective battery module 90 in a step S100. Therein, these measurements can be performed by the control modules 70 specifically in preparation of an authentication of the at least one battery cells 80 or might be regularly obtained by the control modules 70 during normal operation of the battery system 100.

Particularly, the control unit 50 controls each of the control modules 70 via a data line 61 to perform a measurement sequence on at least one of the battery cells 80 of the respective module 90, such that the measurement sequence is performed simultaneously for a plurality of battery cells 80 of the battery system 100. The measurement sequence comprises the detection of a time series of battery current and terminal voltage values for each of the measured battery cells 80, while a defined current, particularly an AC current is applied to each of the measured battery cells 80 within the multiple battery modules 90. Therein, the AC current signal is applied via the control module 70 of the respective battery module 90.

The detected values are either transmitted directly from the respective control modules 70 to the control unit 50 via data lines 61 or might be further processed by the control modules 70. Then, an inherent physical property is determined for each of the measured battery cells 80 based on the measured voltage and current values for this battery cell 80 in a step S200. The inherent physical property is preferably related to a frequency-dependent impedance of the respective measured battery cells 80 and can be considered as a fingerprint of the cells 80. If the inherent physical property of the measured battery cells 80 is determined directly by the control modules 70 under the control of the control unit 50, the determined inherent physical properties are either transmitted from the respective control modules 70 to the control unit 50 via the data lines 61 or are further processed and e.g., stored by the control modules 70 itself.

In a next step S300 of the method of the invention, the determined inherent physical properties are compared with reference values for the respective inherent physical properties. In the described embodiment, a cross-comparison between the inherent physical properties determined for the plurality of measured battery cells 80 is performed. This already allows to identify outliers of the inherent physical properties and to identify cells 80 that can be identified as replacement battery cells. Sometimes, only some battery cells 80 of a battery system 100 need to be replaced at a certain time and hence the inherent physical properties of those cells will differ from the inherent physical properties of the original cells 80 and can thus be used to identify the replacement battery cells. Further, in step S300 the determined inherent physical properties are compared to reference values determined by a mathematical model of the battery cells 80, i.e., simulation of the battery cells 80. Eventually, only outliers of the cross-comparison are compared to the modelled reference values to save resources.

Step S300 is performed by the control unit 50 based on the received or determined values of the inherent physical properties as well as based on reference values stored in or determined by the control unit 50. Alternatively, the comparison is performed by the control modules 70 under the control of the control unit 50, e.g., by using reference values for the inherent physical properties that were transmitted to the control modules 70 from the control unit 50.

Based on the comparison of the determined values and the reference values of the inherent physical properties performed in step S300 an authentication of the measured battery cells 80 is performed in the subsequent step S400. Therein, a battery cell 80 is identified as a replacement battery cell if a deviation between the determined value and the reference value of the inherent physical property exceeds a predetermined threshold. In such a case, a control signal might be generated and transmitted by the control unit 50 or might by received by the control unit 50 from the control module 70. Such control signal is preferably transmitted/forwarded to a control system of a vehicle comprising the battery system 100. Hence, a user can be informed of the replacement battery cell. Also the battery system 100 may be put in a deactivated state in order to avoid any security risks due to operating the battery system 100 while a replacement battery cell is still disposed within the battery system 100. If a deviation between the determined value and the reference value of the inherent physical property is below a predetermined threshold, the respective measured battery cell 80 is preferably identified as an authentic OEM battery cell 80, i.e., is successfully authenticated.

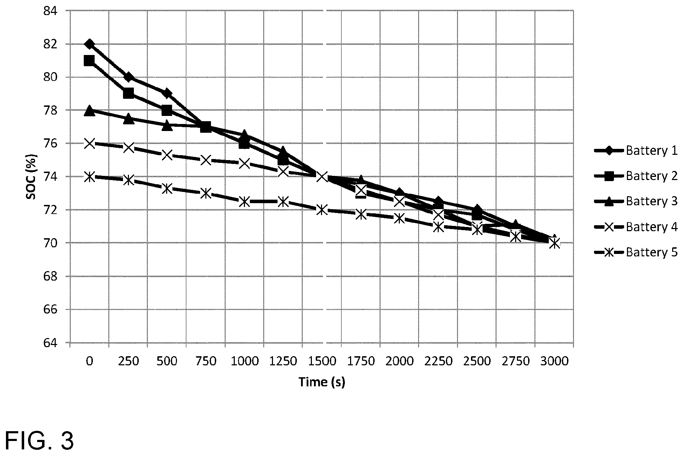

Figure 3 illustrates the state of charge, SOC, over time for a plurality of battery cells, particularly it illustrates the SOC for batteries 1 to 5 during a period between 0 s and 3000 s. As one can see from Figure 3, the time-dependency of a state of a charge differs for individual battery cells and hence the time dependency of a battery cell might be used as a finger print for a particular battery cell. However, at the same time for a plurality of similar battery cells, e.g., battery cells produced by the same original equipment manufacturer, the time dependencies of the SOC of the battery cells 1 to 5 lies within a certain range as shown in Figure 3. Hence, this range of SOC time dependency can be used as a reference value for an inherent physical property of the battery cells from this original manufacturer.

The electronic or electric devices and/or any other relevant devices or components according to embodiments of the present invention described herein may be implemented utilizing any suitable hardware (e.g. a microcontroller), firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of carrier. The conducting elements may comprise metallization, e.g. surface metallizations and/or pins, and/or may comprise conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, RAM. The computer program instructions may also be stored in other nontransitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the embodiments of the present invention.

### Reference signs

- 100: battery system
- 101: first system terminal
- 102: second system terminal

- 90: battery module
- 91: first battery module
- 92: second battery module
- 93: first module terminal
- 94: second module terminal

- 80: battery cell

- 70: cell supervision circuit (CSC)
- 71: first signal port
- 72: second signal port

- 60: busbar
- 61: data line

- 50: battery management system (BMS)
- 51: high voltage (HV) connector
- 52: VEH converter

## Claims

1. Battery system (100) for an electric vehicle, the battery system (100) comprising:
a plurality of battery modules (90), each comprising a plurality of battery cells (80) and a control module (70) connected to the battery cells (80); and
a control unit (50) connected to the battery modules (90) and configured to communicate with the control modules (70) of each of the battery modules (90) via at least one data line (61),
wherein each of the control modules (70) is configured to measure a voltage value, current value and temperature value of at least one of its battery cells (80),
wherein the control unit (50) is configured to:
determine a first inherent physical property of a first battery cell (80) based on first measurement values of voltage, current and/or temperature of the first battery cell (80) from a corresponding control module (70),
determine at least one second inherent physical property of at least one second battery cell (80) based on second measurement values of voltage, current and/or temperature of the at least one second battery cell (80) from at least one corresponding control module (70),
determine a reference value for the first inherent physical property based on the at least one second inherent physical property,
determine a deviation between the reference value and the first inherent physical property and to authenticate the first battery cell (80) if the deviation is below a predetermined threshold,
wherein the first inherent physical property and the at least one second inherent physical property are of the same type and refer to a fingerprint of the respective battery cell that can be determined based on the measurement values of electrical current, electrical voltage and/or temperature of the respective battery cell and that cannot be changed without changing the physical or chemical properties of the respective battery cell.

2. Battery system (100) according to claim 1, wherein the control unit (50) is further configured to identify the first battery cell (80) as replacement battery cell, if the deviation is above a predetermined threshold.

3. Battery system (100) according to claim 1 or 2, wherein the control unit (50) is further configured to trigger the control module (70) to perform a measurement sequence of voltage, current and/or temperature measurements of the first battery cell (80) and the at least one second battery cell (80).

4. Battery system (100) according to claim 3, wherein the measurement sequence comprises voltage, current and/or temperature measurements of the first battery cell (80) and the at least one second battery cell (80) obtained during a predetermined time window.

5. Battery system (100) according to claim 3 or 4, wherein the control unit (50) is further configured to control a specified current draw from and/or a specified current input to the first battery cell (80) and the at least one second battery cell (80) during the measurement sequence.

6. Battery system (100) according to any of the claims 3 to 5, wherein the control unit (50) is further configured to control performance of an impedance spectroscopy on the first battery cell (80) and the at least one second battery cell (80) during the measurement sequence.

7. Battery system (100) according to any of claims 3 to 6, further comprising:
heating elements thermally connected to the first battery cell (80) and the at least one second battery cell (80),
wherein the control unit (50) is further configured to vary a temperature of the first battery cell (80) and the at least one second battery cell (80) during the measurement sequence via the heating elements.

8. Battery system (100) according to any one of the preceding claims, wherein the first inherent physical property comprises at least one of an internal resistance, an impedance, a state of charge, SOC, a state of health, SOH, and a reaction dead time of the first battery cell (80) and the at least one second inherent physical property correspondingly comprises at least one of an internal resistance, an impedance, a state of charge, SOC, a state of health, SOH, and a reaction dead time of the at least one second battery cell (80).

9. Method of operating a battery system (100), the method comprising the steps of:
Measuring first voltage values, first current values and/or first temperature values of a first battery cell (80) of the battery system (100) and determining a first inherent physical property of the first battery cell (80) based on the first values measured for the first battery cell (80);
Measuring second voltage values, second current values and/or second temperature values of at least one second battery cell (80) of the battery system (100) and determining at least one second inherent physical property of the at least one second battery cell (80) based on the second values measured for the at least one second battery cell (80);
Determining a reference value for the first inherent physical property based on the at least one second inherent physical property;
Determining a deviation between the reference value and the first inherent physical property; and
Authentication of the first battery cell (80), if the deviation is below a predetermined threshold,
wherein the first inherent physical property and the at least one second inherent physical property are of the same type and refer to a fingerprint of the respective battery cell that can be determined based on the measurement values of electrical current, electrical voltage and/or temperature of the respective battery cell and that cannot be changed without changing the physical or chemical properties of the respective battery cell.

10. Method according to claim 9, further comprising the steps of:
Identify the first battery cell (80) as replacement battery cell, if the deviation is above a predetermined threshold.

11. Method according to claims 9 or 10, further comprising the steps of:
Performing a measurement sequence of voltage, current and/or temperature measurements of the first battery cell (80) and the at least one second battery cell (80).

12. Method according to claim 11, wherein performing the measurement sequence comprises at least one of:
Measuring voltage, current and/or temperature measurements of the first battery cell (80) and the at least one second battery cell (80) obtained during a predetermined time window;
Drawing a specific current from and/or inputting a specific current to the first battery cell (80) and the at least one second battery cell (80); and
Performing an impedance spectroscopy on the first battery cell (80) and the at least one second battery cell (80).

13. Use of a control unit (50) of a battery system (100) comprising a plurality of battery module (90), each comprising a plurality of battery cells (80) and a control module (70) connected to the battery cells (80) and configured to measure a voltage value, current value and temperature value of at least one of its battery cells (80), the control unit (50) being connected to the battery modules (90) and configured to communicate with the control modules (70) of each of the battery modules (90) via at least one data line (61) for determining a first inherent physical property of a first battery cell (80) based on first measurement values of voltage, current and temperature of the first battery cell (80) obtained from a corresponding control module (70), for determining at least one second inherent physical property of at least one second battery cell (80) based on second measurement values of voltage, current and/or temperature of the at least one second cell (80) from at least one corresponding control module (70), for determining a reference value for the first inherent physical property based on the at least one second inherent physical property, for determining a deviation between the reference value and the first inherent physical property and for authenticating the first battery cell (80) if the deviation is below a predetermined threshold, wherein the first inherent physical property and the at least one second inherent physical property are of the same type and refer to a fingerprint of the respective battery cell that can be determined based on the measurement values of electrical current, electrical voltage and/or temperature of the respective battery cell and that cannot be changed without changing the physical or chemical properties of the respective battery cell.

## Patentansprüche

1. Batteriesystem (100) für ein Elektrofahrzeug, wobei das Batteriesystem (100) Folgendes umfasst:
mehrere Batteriemodule (90), die jeweils mehrere Batteriezellen (80) und ein mit den Batteriezellen (80) verbundenes Steuermodul (70) umfassen; und
eine Steuerung (50), die mit den Batteriemodulen (90) verbunden und dazu konfiguriert ist, über mindestens eine Datenleitung (61) mit den Steuermodulen (70) jedes der Batteriemodule (90) zu kommunizieren,
wobei jedes der Steuermodule (70) dazu konfiguriert ist, einen Spannungswert, einen Stromwert und einen Temperaturwert mindestens einer seiner Batteriezellen (80) zu messen,
wobei die Steuerung (50) dazu konfiguriert ist,
eine erste inhärente physikalische Eigenschaft einer ersten Batteriezelle (80) auf der Grundlage von einem entsprechenden Steuermodul (70) stammender erster Messwerte für Spannung, Strom und/oder Temperatur der ersten Batteriezelle (80) zu bestimmen,
mindestens eine zweite inhärente physikalische Eigenschaft mindestens einer zweiten Batteriezelle (80) auf der Grundlage von mindestens einem entsprechenden Steuermodul (70) stammender zweiter Messwerte für Spannung, Strom und/oder Temperatur der mindestens einen zweiten Batteriezelle (80) zu bestimmen,
einen Referenzwert für die erste inhärente physikalische Eigenschaft auf der Grundlage der mindestens einen zweiten inhärenten physikalischen Eigenschaft zu bestimmen,
eine Abweichung zwischen dem Referenzwert und der ersten inhärenten physikalischen Eigenschaft zu bestimmen und die erste Batteriezelle (80) zu authentifizieren, wenn die Abweichung unter einem vorbestimmten Schwellenwert liegt,
wobei die erste inhärente physikalische Eigenschaft und die mindestens eine zweite inhärente physikalische Eigenschaft vom gleichen Typ sind und sich auf einen Fingerabdruck der jeweiligen Batteriezelle beziehen, der auf der Grundlage der Messwerte von elektrischem Strom, elektrischer Spannung und/oder Temperatur der jeweiligen Batteriezelle bestimmt werden kann und der ohne Änderung der physikalischen oder chemischen Eigenschaften der jeweiligen Batteriezelle nicht geändert werden kann.

2. Batteriesystem (100) nach Anspruch 1, wobei die Steuerung (50) ferner dazu konfiguriert ist, die erste Batteriezelle (80) als Ersatzbatteriezelle zu identifizieren, wenn die Abweichung über einem vorgegebenen Schwellenwert liegt.

3. Batteriesystem (100) nach Anspruch 1 oder 2, wobei die Steuerung (50) ferner dazu konfiguriert ist, das Steuermodul (70) dazu zu veranlassen, eine Messsequenz von Spannungs, Strom- und/oder Temperaturmessungen der ersten Batteriezelle (80) und der mindestens einen zweiten Batteriezelle (80) durchzuführen.

4. Batteriesystem (100) nach Anspruch 3, wobei die Messsequenz Spannungs-, Stromund/oder Temperaturmessungen der ersten Batteriezelle (80) und der mindestens einen zweiten Batteriezelle (80) umfasst, die während eines vorbestimmten Zeitfensters erhalten werden.

5. Batteriesystem (100) nach Anspruch 3 oder 4, wobei die Steuerung (50) ferner dazu konfiguriert ist, während der Messsequenz eine vorgegebene Stromaufnahme aus der ersten Batteriezelle (80) und der mindestens einen zweiten Batteriezelle (80) und/oder eine vorgegebene Stromeingabe in diese zu steuern.

6. Batteriesystem (100) nach einem der Ansprüche 3 bis 5, wobei die Steuerung (50) ferner dazu konfiguriert ist, die Durchführung einer Impedanzspektroskopie an der ersten Batteriezelle (80) und der mindestens einen zweiten Batteriezelle (80) während der Messsequenz zu steuern.

7. Batteriesystem (100) nach einem der Ansprüche 3 bis 6, umfassend ferner:
Heizelemente, die thermisch mit der ersten Batteriezelle (80) und der mindestens einen zweiten Batteriezelle (80) verbunden sind,
wobei die Steuerung (50) ferner dazu konfiguriert ist, während der Messsequenz über die Heizelemente die Temperatur der ersten Batteriezelle (80) und der mindestens einen zweiten Batteriezelle (80) zu ändern.

8. Batteriesystem (100) nach einem der vorstehenden Ansprüche, wobei die erste inhärente physikalische Eigenschaft mindestens eines von Folgendem umfasst: einen Innenwiderstand, eine Impedanz, einen Ladezustand (kurz: SOC), einen Gesundheitszustand (kurz: SOH) und eine Reaktions-Totzeit der ersten Batteriezelle (80), während die mindestens eine zweite inhärente physikalische Eigenschaft entsprechend mindestens eines von Folgendem umfasst: einen Innenwiderstand, eine Impedanz, einen Ladezustand (kurz: SOC), einen Gesundheitszustand (kurz: SOH) und eine Reaktions-Totzeit der mindestens einen zweiten Batteriezelle (80).

9. Verfahren zum Betreiben eines Batteriesystems (100), wobei das Verfahren die folgenden Schritte umfasst:
Messen erster Spannungswerte, erster Stromwerte und/oder erster Temperaturwerte einer ersten Batteriezelle (80) des Batteriesystems (100) und Bestimmen einer ersten inhärenten physikalischen Eigenschaft der ersten Batteriezelle (80) auf der Grundlage der für die erste Batteriezelle (80) gemessenen ersten Werte;
Messen zweiter Spannungswerte, zweiter Stromwerte und/oder zweiter Temperaturwerte mindestens einer zweiten Batteriezelle (80) des Batteriesystems (100) und Bestimmen mindestens einer zweiten inhärenten physikalischen Eigenschaft der mindestens einen zweiten Batteriezelle (80) auf der Grundlage der für die mindestens eine zweite Batteriezelle (80) gemessenen zweiten Werte;
Bestimmen eines Referenzwerts für die erste inhärente physikalische Eigenschaft auf der Grundlage der mindestens einen zweiten inhärenten physikalischen Eigenschaft;
Bestimmen einer Abweichung zwischen dem Referenzwert und der ersten inhärenten physikalischen Eigenschaft; und
Authentifizieren der ersten Batteriezelle (80), wenn die Abweichung unter einem vorbestimmten Schwellenwert liegt,
wobei die erste inhärente physikalische Eigenschaft und die mindestens eine zweite inhärente physikalische Eigenschaft vom gleichen Typ sind und sich auf einen Fingerabdruck der jeweiligen Batteriezelle beziehen, der auf der Grundlage der Messwerte von elektrischem Strom, elektrischer Spannung und/oder Temperatur der jeweiligen Batteriezelle bestimmt werden kann und der ohne Änderung der physikalischen oder chemischen Eigenschaften der jeweiligen Batteriezelle nicht geändert werden kann.

10. Verfahren nach Anspruch 9, umfassend ferner die folgenden Schritte:
Identifizieren der ersten Batteriezelle (80) als Ersatzbatteriezelle, wenn die Abweichung über einem vorbestimmten Schwellenwert liegt.

11. Verfahren nach Anspruch 9 oder 10, umfassend ferner die folgenden Schritte:
Durchführen einer Messsequenz von Spannungs-, Strom- und/oder Temperaturmessungen der ersten Batteriezelle (80) und der mindestens einen zweiten Batteriezelle (80).

12. Verfahren nach Anspruch 11, wobei das Durchführen der Messsequenz mindestens eines von Folgendem umfasst:
Durchführen von Spannungs-, Strom- und/oder Temperaturmessungen der ersten Batteriezelle (80) und der mindestens einen zweiten Batteriezelle (80), die während eines vorbestimmten Zeitfensters erhalten werden;
Abnehmen eines vorgegebenen Stroms von und/oder Einspeisen eines vorgegebenen Stroms in die erste Batteriezelle (80) und die mindestens eine zweite Batteriezelle (80); und
Durchführen einer Impedanzspektroskopie an der ersten Batteriezelle (80) und der mindestens einen zweiten Batteriezelle (80).

13. Verwendung einer Steuerung (50) eines Batteriesystems (100), das mehrere Batteriemodule (90) umfasst, von denen jedes mehrere Batteriezellen (80) und ein Steuermodul (70) umfasst, das mit den Batteriezellen (80) verbunden und dazu konfiguriert ist, einen Spannungswert, einen Stromwert und einen Temperaturwert mindestens einer seiner Batteriezellen (80) zu messen, wobei die Steuerung (50) mit den Batteriemodulen (90) verbunden und dazu konfiguriert ist, mit den Steuermodulen (70) jedes der Batteriemodule (90) über mindestens eine Datenleitung (61) zu kommunizieren, um eine erste inhärente physikalische Eigenschaft einer ersten Batteriezelle (80) auf der Grundlage erster Messwerte für Spannung, Strom und Temperatur der ersten Batteriezelle (80), die von einem entsprechenden Steuermodul (70) erhalten werden, zu bestimmen, um mindestens eine zweite inhärente physikalische Eigenschaft mindestens einer zweiten Batteriezelle (80) auf der Grundlage von mindestens einem entsprechenden Steuermodul (70) stammender zweiter Messwerte für Spannung, Strom und/oder Temperatur der mindestens einen zweiten Zelle (80) zu bestimmen, um einen Referenzwert für die erste inhärente physikalische Eigenschaft auf der Grundlage der mindestens einen zweiten inhärenten physikalischen Eigenschaft zu bestimmen, um eine Abweichung zwischen dem Referenzwert und der ersten inhärenten physikalischen Eigenschaft zu bestimmen und um die erste Batteriezelle (80) zu authentifizieren, wenn die Abweichung unter einem vorbestimmten Schwellenwert liegt, wobei die erste inhärente physikalische Eigenschaft und die mindestens eine zweite inhärente physikalische Eigenschaft vom gleichen Typ sind und sich auf einen Fingerabdruck der jeweiligen Batteriezelle beziehen, der auf der Grundlage der Messwerte von elektrischem Strom, elektrischer Spannung und/oder Temperatur der jeweiligen Batteriezelle bestimmt werden kann und der ohne Änderung der physikalischen oder chemischen Eigenschaften der jeweiligen Batteriezelle nicht geändert werden kann.

## Revendications

1. Système de batterie (100) pour un véhicule électrique, le système de batterie (100) comportant :
une pluralité de modules de batterie (90), comportant chacun une pluralité de cellules de batterie (80) et un module de commande (70) connecté aux cellules de batterie (80) ; et
une unité de commande (50) connectée aux modules de batterie (90) et configurée pour communiquer avec les modules de commande (70) de chacun des modules de batterie (90) par le biais d'au moins une ligne de données (61),
dans lequel chacun des modules de commande (70) est configuré pour mesurer une valeur de tension, une valeur de courant et une valeur de température d'au moins l'une de ses cellules de batterie (80),
dans lequel l'unité de commande (50) est configurée pour :
déterminer une première propriété physique inhérente d'une première cellule de batterie (80) sur la base de premières valeurs de mesure de tension, de courant et/ou de température de la première cellule de batterie (80) à partir d'un module de commande (70) correspondant,
déterminer au moins une seconde propriété physique inhérente d'au moins une seconde cellule de batterie (80) sur la base de secondes valeurs de mesure de tension, de courant et/ou de température de l'au moins une seconde cellule de batterie (80) à partir d'au moins un module de commande (70) correspondant,
déterminer une valeur de référence pour la première propriété physique inhérente sur la base de l'au moins une seconde propriété physique inhérente,
déterminer un écart entre la valeur de référence et la première propriété physique inhérente et authentifier la première cellule de batterie (80) si l'écart est inférieur à un seuil prédéterminé,
dans lequel la première propriété physique inhérente et l'au moins une seconde propriété physique inhérente sont du même type et font référence à une empreinte digitale de la cellule de batterie respective qui peut être déterminée sur la base des valeurs de mesure de courant électrique, de tension électrique et/ou de température de la cellule de batterie respective et qui ne peut être modifiée sans modifier les propriétés physiques ou chimiques de la cellule de batterie respective.

2. Système de batterie (100) selon la revendication 1, dans lequel l'unité de commande (50) est en outre configurée pour identifier la première cellule de batterie (80) comme cellule de batterie de remplacement, si l'écart est supérieur à un seuil prédéterminé.

3. Système de batterie (100) selon la revendication 1 ou 2, dans lequel l'unité de commande (50) est en outre configurée pour déclencher le module de commande (70) pour effectuer une séquence de mesure de tension, de courant et/ou de température de la première cellule de batterie (80) et de l'au moins une seconde cellule de batterie (80).

4. Système de batterie (100) selon la revendication 3, dans lequel la séquence de mesure comporte des mesures de tension, de courant et/ou de température de la première cellule de batterie (80) et de l'au moins une seconde cellule de batterie (80) obtenues pendant une fenêtre de temps prédéterminée.

5. Système de batterie (100) selon la revendication 3 ou 4, dans lequel l'unité de commande (50) est en outre configurée pour commander un prélèvement de courant spécifié à partir de la première cellule de batterie (80) et de l'au moins une seconde cellule de batterie (80) et/ou une entrée de courant spécifiée vers celles-ci pendant la séquence de mesure.

6. Système de batterie (100) selon l'une quelconque des revendications 3 à 5, dans lequel l'unité de commande (50) est en outre configurée pour commander la performance d'une spectroscopie d'impédance sur la première cellule de batterie (80) et l'au moins une seconde cellule de batterie (80) pendant la séquence de mesure.

7. Système de batterie (100) selon l'une quelconque des revendications 3 à 6, comportant en outre :
des éléments chauffants connectés thermiquement à la première cellule de batterie (80) et à l'au moins une seconde cellule de batterie (80),
dans lequel l'unité de commande (50) est en outre configurée pour faire varier une température de la première cellule de batterie (80) et de l'au moins une seconde cellule de batterie (80) pendant la séquence de mesure par le biais des éléments chauffants.

8. Système de batterie (100) selon l'une quelconque des revendications précédentes, dans lequel la première propriété physique inhérente comporte au moins l'une parmi une résistance interne, une impédance, un état de charge, SOC, un état de santé, SOH, et un temps mort de réaction de la première cellule de batterie (80) et l'au moins une seconde propriété physique inhérente comporte de manière correspondante au moins l'une parmi une résistance interne, une impédance, un état de charge, SOC, un état de santé, SOH, et un temps mort de réaction de l'au moins une seconde cellule de batterie (80).

9. Procédé de fonctionnement d'un système de batterie (100), le procédé comportant les étapes consistant à :
mesurer de premières valeurs de tension, de premières valeurs de courant et/ou de premières valeurs de température d'une première cellule de batterie (80) du système de batterie (100) et déterminer une première propriété physique inhérente de la première cellule de batterie (80) sur la base des premières valeurs mesurées pour la première cellule de batterie (80) ;
mesurer de secondes valeurs de tension, de secondes valeurs de courant et/ou de secondes valeurs de température d'au moins une seconde cellule de batterie (80) du système de batterie (100) et déterminer au moins une seconde propriété physique inhérente de l'au moins une seconde cellule de batterie (80) sur la base des secondes valeurs mesurées pour l'au moins une seconde cellule de batterie (80) ;
déterminer une valeur de référence pour la première propriété physique inhérente sur la base de l'au moins une seconde propriété physique inhérente ;
déterminer un écart entre la valeur de référence et la première propriété physique inhérente ; et
authentifier la première cellule de batterie (80), si l'écart est inférieur à un seuil prédéterminé,
dans lequel la première propriété physique inhérente et l'au moins une seconde propriété physique inhérente sont du même type et font référence à une empreinte digitale de la cellule de batterie respective qui peut être déterminée sur la base des valeurs de mesure de courant électrique, de tension électrique et/ou de température de la cellule de batterie respective et qui ne peut être modifiée sans modifier les propriétés physiques ou chimiques de la cellule de batterie respective.

10. Procédé selon la revendication 9, comportant en outre les étapes consistant à :
identifier la première cellule de batterie (80) comme cellule de batterie de remplacement, si l'écart est supérieur à un seuil prédéterminé.

11. Procédé selon la revendication 9 ou 10, comportant en outre les étapes consistant à :
effectuer une séquence de mesure de tension, de courant et/ou de température de la première cellule de batterie (80) et de l'au moins une seconde cellule de batterie (80).

12. Procédé selon la revendication 11, dans lequel la réalisation de la séquence de mesure comporte au moins l'un parmi :
la réalisation de mesures de tension, de courant et/ou de température de la première cellule de batterie (80) et de l'au moins une seconde cellule de batterie (80) obtenues pendant une fenêtre de temps prédéterminée ;
le prélèvement d'un courant spécifique à partir de la première cellule de batterie (80) et de l'au moins une seconde cellule de batterie (80) et/ou une entrée d'un courant spécifique vers celles-ci ; et
la réalisation d'une spectroscopie d'impédance sur la première cellule de batterie (80) et l'au moins une seconde cellule de batterie (80).

13. Utilisation d'une unité de commande (50) d'un système de batterie (100) comportant une pluralité de modules de batterie (90), comportant chacun une pluralité de cellules de batterie (80) et un module de commande (70) connecté aux cellules de batterie (80) et configuré pour mesurer une valeur de tension, une valeur de courant et une valeur de température d'au moins l'une de ses cellules de batterie (80), l'unité de commande (50) étant connectée aux modules de batterie (90) et configurée pour communiquer avec les modules de commande (70) de chacun des modules de batterie (90) par le biais d'au moins une ligne de données (61) pour déterminer une première propriété physique inhérente d'une première cellule de batterie (80) sur la base de premières valeurs de mesure de tension, de courant et de température de la première cellule de batterie (80) obtenues à partir d'un module de commande (70) correspondant, pour déterminer au moins une seconde propriété physique inhérente d'au moins une seconde cellule de batterie (80) sur la base de secondes valeurs de mesure de tension, de courant et/ou de température de l'au moins une seconde cellule (80) à partir d'au moins un module de commande (70) correspondant, pour déterminer une valeur de référence pour la première propriété physique inhérente sur la base de l'au moins une seconde propriété physique inhérente, pour déterminer un écart entre la valeur de référence et la première propriété physique inhérente et pour authentifier la première cellule de batterie (80) si l'écart est inférieur à un seuil prédéterminé, dans lequel la première propriété physique inhérente et l'au moins une seconde propriété physique inhérente sont du même type et font référence à une empreinte digitale de la cellule de batterie respective qui peut être déterminée sur la base des valeurs de mesure de courant électrique, de tension électrique et/ou de température de la cellule de batterie respective et qui ne peut être modifiée sans modifier les propriétés physiques ou chimiques de la cellule de batterie respective.
